# EUROPÄISCHE PATENTSCHRIFT

(11) **EP 2 601 715 B1**
(45) Veröffentlichungstag und Bekanntmachung des Hinweises auf die Patenterteilung: **28.01.2015**
(21) Anmeldenummer: 11751565.0
(22) Anmeldetag: 05.08.2011
(51) Int. Cl.: H01T 1/14, H01H 37/76, H05K 1/02

(54) **THERMISCHE ÜBERLASTSCHUTZVORRICHTUNG**
THERMAL OVERLOAD PROTECTION APPARATUS
DISPOSITIF DE PROTECTION CONTRE LES SURCHARGES THERMIQUES

(30) Priorität: 08.10.2010 DE 102010038070; 06.08.2010 DE 102010036907
(43) Veröffentlichungstag der Anmeldung: 12.06.2013
(73) Patentinhaber: Phoenix Contact GmbH & Co. KG, 32825 Blomberg (DE)
(72) Erfinder: MEYER, Thomas, 31868 Ottenstein (DE); PFÖRTNER, Steffen, 31832 Springe (DE); BERG, Peter, 33189 Schlangen (DE)
(74) Vertreter: Michalski Hüttermann & Partner Patentanwälte mbB
(86) Internationale Anmeldenummer: PCT/EP2011/063517
(87) Internationale Veröffentlichungsnummer: WO 2012/017070

(56) Entgegenhaltungen:
- WO-A1-2007/125000
- DE-A1-102008 022 794
- FR-A1- 2 914 108
- JP-A- 4 162 323
- JP-A- 4 209 557

## Beschreibung

Die Erfindung betrifft eine thermische Überlastschutzvorrichtung zum Schutz eines elektrischen Bauelements, insbesondere elektronischen Bauelements, die ein Schaltelement zum Kurzschließen von Anschlüssen des Bauelements oder zum Auftrennen einer elektrisch leitenden Verbindung zwischen mindestens einem der Anschlüsse und einem Stromführungselement der Überlastschutzvorrichtung, eine Aktorvorrichtung zum Verlagern des Schaltelements in eine entsprechende Kurzschlussposition oder Trennposition und ein die Aktorvorrichtung thermosensitiv auslösendes Auslöseelement aufweist.

Eine derartige Überlastschutzvorrichtung ist zum Beispiel aus der Offenlegungsschrift DE 10 2008 022 794 A1 bekannt. Diese beschreibt eine thermische Überlastschutzvorrichtung, die eine Kurzschlusseinrichtung mit federvorgespanntem Kurzschlussbügel zum Kurzschließen von Elektroden eines Überspannungsableiters und ein die Überlastschutzvorrichtung auslösendes Schmelzelement aufweist. Neben dieser Ausführung als Überlastschutzvorrichtung mit Schaltelement einer Kurzschlusseinrichtung ist auch eine Überlastschutzvorrichtung mit entsprechendem Schaltelement einer Abtrenneinrichtung denkbar.

Die Überbeanspruchung von elektronischen Bauelementen kann dazu führen, dass diese außerhalb eines Nennbetriebsbereiches arbeiten. Dabei führt ein zum Beispiel durch eine reduzierte Isolationsfestigkeit des Bauelements hervorgerufener Leistungsumsatz an einem geschädigten Bauelement zu einer erhöhten Erwärmung. Wird eine Erwärmung des Bauelements über eine Zulässigkeitsschwelle hinaus nicht verhindert, kann dies zum Beispiel zur Schädigung umgebender Materialien, Entstehung von Rauchgasen oder zu einer Brandgefahr führen.

Diese Gefahren ergeben sich auch bei einer Anordnung von auf einem Leiterbahnenträger angeordneten Bauelementen wie zum Beispiel oberflächenmontierbaren Bauelementen. Zum Aufbau einer derartigen Anordnung wird der Leiterbahnenträger (die Leiterplatte/Platine) mit entsprechenden Bauelementen zumeist von Automaten bestückt und verlötet. Aufgrund der dichten Bestückung ergibt sich oft nur ein sehr begrenzter Bauraum. Gleichzeitig entstehen lokal Temperaturen, die zumindest nahe an die Auslösetemperatur des Auslöseelements heranreichen.

Die Druckschrift FR 07 53944 A1 zeigt eine thermische Überlastschutzvorrichtung zum Schutz eines elektrischen Bauelements. Die Vorrichtung weist folgende Elemente auf: einen Kontaktbügel zum Auftrennen einer elektrisch leitenden Verbindung zwischen mindestens einem von mehreren Anschlüssen des Bauelements und einer Leiterbahn der Überlastschutzvorrichtung und ein den Kontaktbügel thermosensitiv auslösendes Lot als Auslöseelement. Der Kontaktbügel weist seinerseits einen vorgespannten, verformbaren Teil zum Verlagern des Kontaktbügels in eine entsprechende Trennposition und eine Sperrklinke zum Halten des Kontaktbügels in einer nichtaktivierten Stellung auf. Der verformbare Bügelteil ist zu seiner Aktivierung von einem inaktiven Zustand, bei dem der Rest des Kontaktbügels von dem Bügelteil auch durch Auslösen mittels Auslöseelement nicht verlagerbar ist, durch das Lösen der Sperrklinke in einen auslösbaren Zustand umschaltbar, bei dem der Rest des Kontaktbügels von dem Bügelteil verlagerbar ist.

Der Erfindung liegt die Aufgabe zu Grunde, eine alternative thermische Überlastschutzvorrichtung anzugeben, welche wenig Bauraum benötigt, sicher auf thermische Überlast anspricht und kurzschließt beziehungsweise trennt und sich trotz der dabei entstehenden Temperaturen einfach in einen Montageprozess einer Montage, insbesondere Oberflächenmontage, von Bauelementen auf einem Leiterbahnenträger integrieren lässt.

Die Lösung der Aufgabe erfolgt erfindungsgemäß durch die Merkmale des unabhängigen Anspruchs. Vorteilhafte Ausgestaltungen der Erfindung sind in den Unteransprüchen angegeben.

Bei der erfindungsgemäßen Überlastschutzvorrichtung ist vorgesehen, dass die Aktorvorrichtung zu ihrer Aktivierung von einem inaktiven Zustand, bei dem das Schaltelement von der Aktorvorrichtung auch durch Auslösen mittels Auslöseelement nicht verlagerbar ist, in einen auslösbaren Zustand umschaltbar ist, bei dem das Schaltelement von der mittels Auslöseelement auslösbaren Aktorvorrichtung verlagerbar ist. Die Begriffe "inaktiv" und "auslösbar" bedeutet also in diesem Zusammenhang, dass nur die durch das Umschalten aktivierte Aktorvorrichtung bei einem Auslösen eine zum Kurzschließen oder Trennen benötigte Kraft aufbringt und die nicht aktivierte, also inaktive Aktorvorrichtung selbst bei einem Auslösen mittels Auslöseelement keine oder eine zum Kurzschließen oder Trennen nicht ausreichende Kraft aufbringt. Eine derartige Überlastschutzvorrichtung kann ohne die Gefahr eines Auslösens auch mittels einer mit hohen Temperaturen verbundenen Montageart, wie zum Beispiel einem Löten, montiert werden. Dadurch wird ermöglicht, dass ein Aktivieren erst nach Erreichen einer unkritischen Temperatur oder zu einem anderen beliebig wählbaren Zeitpunkt möglich ist. Dieser Zeitpunkt kann insbesondere nach Abschluss der Montage der Überlastschutzvorrichtung und/oder des elektrischen Bauelements sein.

Weiterhin ist vorgesehen, dass die Aktorvorrichtung im umgeschalteten Zustand eine mittels einer Verrastung am Schaltelement mechanisch vorgespannte Aktorvorrichtung ist. Teile der Aktorvorrichtung und/oder des Schaltelements sind bei umgeschalteter Aktorvorrichtung somit miteinander verrastet oder stehen in einem sonstigen Wirkeingriff miteinander um die Aktorvorrichtung vorzuspannen.

Das Bauelement ist bevorzugt ein mit seinen Anschlüssen auf einem Leiterbahnenträger mit Leiterbahnen montierbares beziehungsweise montiertes Bauelement. Das Stromführungselement der elektrisch leitenden Verbindung bei einem als Trenneinrichtung ausgebildeten elektrischen Schaltelement ist insbesondere eine der Leiterbahnen oder ein auf dem Leiterbahnenträger montiertes und mit einer der Leiterbahnen verschaltetes Stromführungselement. Die elektrisch leitende Verbindung ist eine Verbindung zur Beschaltung des Bauelements. Das Kurzschließen ist insbesondere ein Kurzschließen über mindestens eine der Leiterbahnen.

Mit Vorteil ist vorgesehen, dass das Auslöseelement als ein durch Schmelzen auslösendes Schmelzelement ausgebildet ist. Die Schmelztemperatur des Schmelzelements bestimmt die Auslösetemperatur, die somit über die Materialwahl einstellbar ist. Das Schmelzelement weist als aktives Material zum Beispiel Lot oder einen Schmelzkunststoff auf.

Verglichen mit einem Lot zeigt Schmelzkunststoff einen weicheren Übergang seiner Konsistenz am Schmelzpunkt. Dies hat den Vorteil, dass ein Auslöseelement aus Schmelzkunststoff auch im Auslösefall an seinem ursprünglichen Ort verbleibt und durch das Auslösen lediglich seine Form derart verändert, dass die Kurzschlusseinrichtung das Bauelement kurzschließen kann.

Ist das Schaltelement als eine Trenneinrichtung zum Auftrennen einer elektrisch leitenden Verbindung mindestens eines der Anschlüsse mit einem Stromführungselement ausgebildet, so ist das Schmelzelement bevorzugt eine Lotverbindung innerhalb der (aufzutrennenden) elektrisch leitenden Verbindung.

Gemäß einer bevorzugten Ausgestaltung der Erfindung ist vorgesehen, dass die Aktorvorrichtung eine durch manuelle Veränderung der äußeren Form der Aktorvorrichtung oder der Anordnung der Aktorvorrichtung relativ zum Schaltelement umschaltbare Aktorvorrichtung ist. Das Umschalten ist somit ein manuelles Umschalten durch Veränderung der äußeren Form der Aktorvorrichtung oder durch Veränderung der Anordnung der Aktorvorrichtung relativ zum Schaltelement. Die Aktivierung kann unmittelbar an der Überlastschutzvorrichtung vorgenommen werden. Der Zeitpunkt der Aktivierung kann von einem Nutzer frei gewählt werden.

Gemäß einer vorteilhaften Ausgestaltung der Erfindung ist vorgesehen, dass die Aktorvorrichtung mindestens ein Federelement aufweist, insbesondere ein Federelement ist. Durch Vorspannen des Federelements wird die Aktorvorrichtung umgeschaltet. Insbesondere ist dabei vorgesehen, dass das Federelement eine Schnappscheibe ist oder eine Schnappscheibe aufweist. Schnappscheiben sind Federelemente, die nach dem Knackfrosch-Prinzip arbeiten. Ein Knackfrosch ist ein Federelement, das aus einem Streifen Federstahl besteht. Der Stahl ist so geprägt, dass er einen stabilen und einen metastabilen Zustand aufweist. Durch Krafteinwirkung im stabilen Zustand wird er verbogen, bis er plötzlich durch Beulen in den metastabilen Zustand springt. Zumeist weist das Federelement des Knackfroschs einen Kuppel- oder Kuppelabschnittsartigen Bereich aus, der durch das Prägen erzeugt wird. Die beiden Zustände werden in dieser Ausgestaltung der Erfindung bevorzugt dazu genutzt, einen entspannten und einen vorgespannten Zustand des Federelements zu erzeugen. Das Umschalten ist dabei ein Umschalten vom ungespannten in den vorgespannten Zustand.

Alternativ oder zusätzlich ist mit Vorteil vorgesehen, dass die Aktorvorrichtung ein intumeszentes Material und/oder ein Formgedächtnismaterial und/oder ein seine Form chemisch veränderndes Material als aktives Material aufweist.

Alternativ oder zusätzlich ist mit Vorteil vorgesehen, dass die Aktorvorrichtung eine mittels gegenseitiger Verlagerung von Teilen oder Bereichen der Aktorvorrichtung umschaltbare (und somit aktivierbare) Einrichtung ist. Weist die Aktorvorrichtung ein nach dem Knackfrosch-Prinzip arbeitendes Federelement (eine Schnappscheibe) auf, so ist die Verlagerung ein Einbeulen eines Bereichs dieses Federelements.

Gemäß einer Weiterbildung der Erfindung ist vorgesehen, dass das Schaltelement und die Aktorvorrichtung einstückig ausgebildet sind oder zumindest ein einstückig ausgebildetes gemeinsames Teil aufweisen. Dies reduziert die Anzahl der benötigten Teile und gibt eine eindeutige Verbindung zwischen Schaltelement und Aktorvorrichtung vor.

Gemäß einer bevorzugten Ausführungsform der Erfindung ist vorgesehen, dass das Bauelement ein von der Überlastschutzvorrichtung, insbesondere von dem Schaltelement, separierbares Bauelement ist. Bauelement und Überlastschutzvorrichtung können somit -zumindest prinzipiell- unabhängig von einander manipuliert werden. Dieser Freiheitsgrad vereinfacht insbesondere die Montage von Bauelement und/oder Überlastschutzvorrichtung.

Die Erfindung betrifft weiterhin eine Anordnung mit einem Leiterbahnenträger, mindestens einem darauf angeordneten Bauelement und mindestens einer vorstehend genannten Überlastschutzvorrichtung. Das Bauelement ist bevorzugt ein Überspannungsschutzableiter, insbesondere auf Halbleiterbasis (Suppressordiode, Varistor, etc.) oder ein gasgefüllter Überspannungsableiter oder ein Widerstand.

Insbesondere ist das Bauelement ein oberflächenmontiertes Bauelement (SMD-Bauelement), das bevorzugt mittels Wiederraufschmelz-Lötprozess (Reflow-Lötprozess) auf den Leiterbahnen des Leiterbahnträgers montiert ist.

Gemäß einer bevorzugten Ausführungsform der Erfindung ist vorgesehen, dass sich das Schaltelement und/oder die Aktorvorrichtung der Überlastschutzvorrichtung über das Auslöseelement (also mittelbar) am Bauelement oder einer mit einem Anschluss des Bauelements unmittelbar verbundenen Leiterbahn des Leiterbahnenträgers abstützt. Alternativ oder zusätzlich ist insbesondere vorgesehen, dass sich das Schaltelement und/oder die Aktorvorrichtung der Überlastschutzvorrichtung unmittelbar an mindestens einer einen der Anschlüsse kontaktierenden Leiterbahnen abstützen.

Nachfolgend wird die Erfindung unter Bezugnahme auf die anliegende Zeichnung anhand bevorzugter Ausführungsformen näher erläutert.

Es zeigen
Fig. 1A - 1C eine thermische Überlastschutzvorrichtung zum Trennen einer elektrischen Verbindung in einer schematischen Darstellung,
Fig. 2 die Aktorvorrichtung der thermischen Überlastschutzvorrichtung der Figuren 1A - 1C in einer Draufsicht,
Fig. 3A - 3C eine thermische Überlastschutzvorrichtung zum Trennen einer elektrischen Verbindung gemäß einer Ausführungsform der Erfindung in einer schematischen Darstellung,
Fig. 4 ein elektronisches Bauelement und eine thermische Überlastschutzvorrichtung im nicht-aktiven Betriebszustand,
Fig. 5 das Bauelement und die thermische Überlastschutzvorrichtung der Figur 4 im aktivierten Betriebszustand,
Fig. 6 das Bauelement und die thermische Überlastschutzvorrichtung der Figuren 4 und 5 im ausgelösten Betriebszustand,
Fig. 7 ein elektronisches Bauelement und eine thermische Überlastschutzvorrichtung im nicht-aktivierten Betriebszustand,
Fig. 8 das Bauelement und die thermische Überlastschutzvorrichtung der Figur 7 im aktivierten Betriebszustand und
Fig. 9 das Bauelement und die thermische Überlastschutzvorrichtung der Figuren 7 und 8 im ausgelösten Betriebszustand.

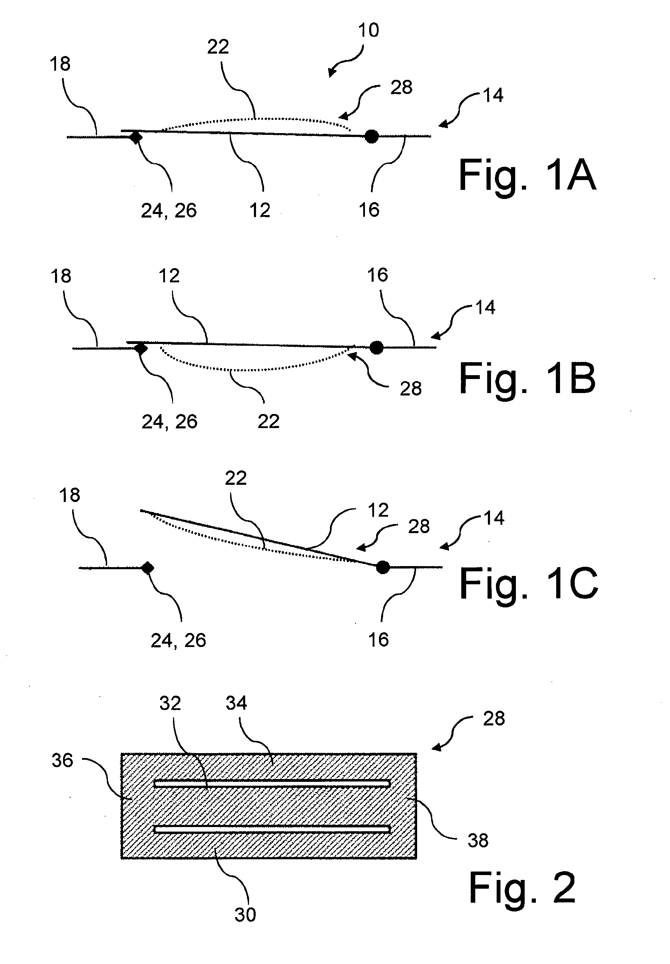

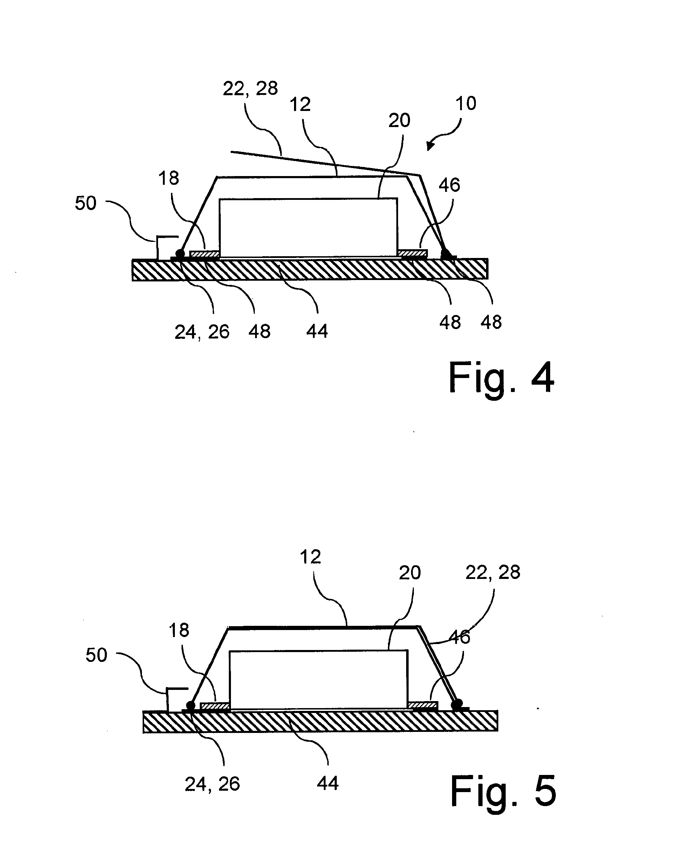

Die Figuren 1A bis 1C zeigen in einer schematischen Darstellung einen Teil einer thermischen Überlastschutzvorrichtung 10. Dieser Teil umfasst ein Schaltelement 12 zum Auftrennen einer elektrisch leitenden Verbindung 14 zwischen einem Stromführungselement 16 und einem Anschluss 18 eines in den konkreten Ausführungsbeispielen der Figuren 4 bis 9 gezeigten elektrischen Bauelements 20. Weiterhin umfasst dieser Teil eine Aktorvorrichtung 22 und ein die Aktorvorrichtung 22 thermosensitiv auslösendes Auslöseelement 24. Dieses Auslöseelement 24 ist in dem Beispiel der Figuren 1A bis 1C als Schmelzelement 26 ausgebildet. Dieses Schmelzelement 26 ist eine Lotverbindung innerhalb der elektrisch leitenden Verbindung 14, wobei die Lotverbindung einen Stromfluss durch die nichtaufgetrennte Verbindung 16 ermöglicht.

Die Fig. 1A zeigt die elektrisch leitende Verbindung 16 mit dem Schaltelement 12 und der Aktorvorrichtung 22 in einem inaktiven Zustand, bei dem das Schaltelement 12 von der Aktorvorrichtung 22 auch durch Auslösen mittels Auslöseelement 24 nicht verlagerbar ist beziehungsweise verlagert wird, da die Aktorvorrichtung in diesem Zustand kraftfrei ist (F = 0N). Die Aktorvorrichtung 22 ist dabei als ein nach dem Knackfrosch-Prinzip arbeitendes Federelement 28 ausgebildet. Teile dieses Federelements 28 dienen gleichzeitig auch als Schaltelement 12. Somit sind Schaltelement 12 und Aktorvorrichtung 22 als einstückiges Federelement 28 ausgebildet.

Fig. 2 zeigt dieses Federelement 28 in einer Draufsicht. Das Federelement 28 weist drei parallel zueinander verlaufende streifenförmige Bereiche 30, 32, 34 auf, die an ihren jeweiligen Enden über Endbereiche 36, 38 des Federelements 28 fest miteinander verbunden sind. Mindestens einer der streifenförmigen Bereiche 32 (zum Beispiel durch eine Prägung) ist länger als die anderen streifenförmigen Bereiche 30, 34. Diese anderen streifenförmigen Bereiche 30, 34 sind zum Beispiel völlig Plan, während der längere streifenförmige Bereich (beispielsweise der mittlere Bereich) 32 durch die Prägung in eine Vorzugsrichtung beult. Das Federelement 28 kann nun durch Umbeulen des längeren streifenförmigen Bereichs 32 von dem einem Zustand in einen anderen Zustand, bei dem er -zumindest bereichsweise- in die andere Richtung beult, umgeschaltet werden. Der eine Zustand ist der kraftfreie Zustand mit F = 0N und im anderen Zustand ist das Federelement 28 vorgespannt. Obwohl das gezeigte Federelement 28 keine Schnappscheibe ist, so weist es doch das gleiche Wirkprinzip auf, nämlich das Wirkprinzip eines sogenannten Knackfroschs.

Der eine Endbereich 36 des Federelements 28 ist gleichzeitig Endbereich 36 des Schaltelements 12 und als solcher im ungetrennten Zustand mittels des als Lotverbindung ausgebildeten Schmelzelements 26 mit dem Anschluss 18 verbunden. Der andere Endbereich 38 des Federelements 28 ist gleichzeitig anderer Endbereich 38 des Schaltelements 12 und als solcher permanent mit dem Stromführungselement 16 verbunden.

Die Fig. 1B zeigt die elektrisch leitende Verbindung 16 mit dem Schaltelement 12 und der Aktorvorrichtung 22 nach einem Umschalten in einen auslösbaren Zustand, bei dem das Schaltelement 12 von der mittels des Auslöseelements 24 auslösbaren Aktorvorrichtung 22 verlagerbar ist. Die Fig. 1C zeigt die aufgetrennte Verbindung 16 mit dem Schaltelement 12 und der Aktorvorrichtung 22 nach einem Umschalten in den auslösbaren Zustand, bei dem das Schaltelement 12 von der mittels des Auslöseelements 24 auslösbaren Aktorvorrichtung 22 verlagerbar ist, und einem anschließenden Auslösen durch das Auslöseelement 24.

Der vorgespannte mittlere streifenförmige Bereich 32 des Federelements 28 zieht den einen Endbereich 36 vom Schmelzelement 26 weg, sodass die elektrisch leitende Verbindung 14 getrennt wird.

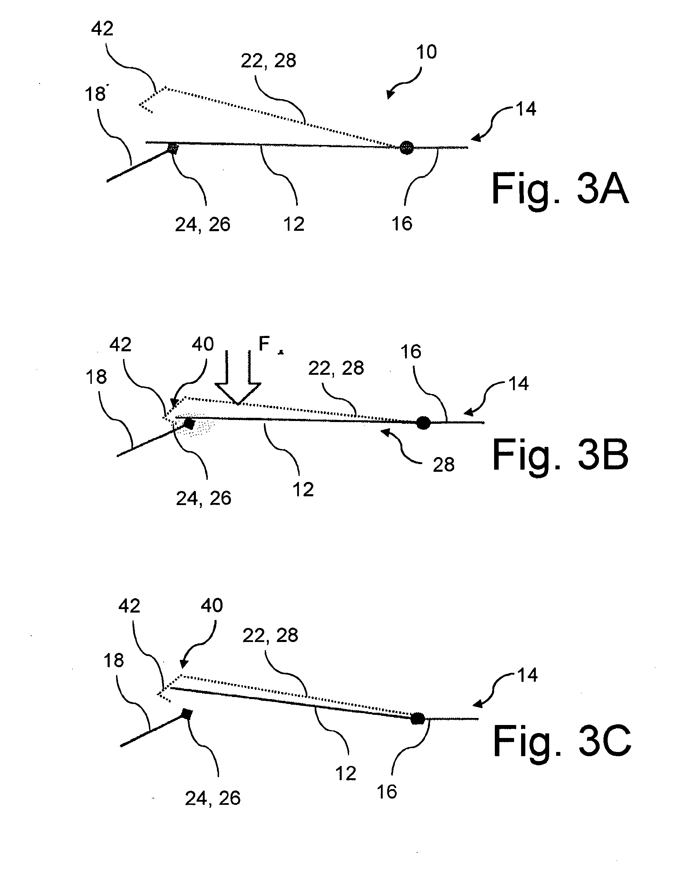

Der in den Figuren 3A bis 3C gezeigte Teil der thermischen Überlastschutzvorrichtung 10 entspricht im Wesentlichen der Überlastschutzvorrichtung 10 der Figuren 1A bis 1C, sodass hier nur auf die Unterschiede eingegangen werden soll.

Die Fig. 3A zeigt die elektrisch leitende Verbindung 16 mit dem Schaltelement 12 und der Aktorvorrichtung 22 in einem inaktiven Zustand, bei dem das Schaltelement 12 von der Aktorvorrichtung 22 auch durch ein Auslösen mittels des Auslöseelements 24 nicht verlagerbar ist beziehungsweise verlagert wird, da die Aktorvorrichtung in diesem Zustand keine abtrennende Kraft auf das Schaltelement 12 ausübt(F = 0N). Das Auslöseelement 24 ist auch hier als Schmelzelement 26 ausgebildet.

Die Fig. 3B zeigt die elektrisch leitende Verbindung 16 mit dem Schaltelement 12 und der Aktorvorrichtung 22 nach einem Umschalten in einen auslösbaren Zustand, bei dem das Schaltelement 12 von der mittels des Auslöseelements 24 auslösbaren Aktorvorrichtung 22 verlagerbar ist. Mittels der manuell aufzubringenden Kraft (Pfeil F) wird die Aktorvorrichtung 22 gegenüber dem Schaltelement 12 so verschwenkt/verbogen, dass die Aktorvorrichtung 22 mittels einer Verrastung 40 am Schaltelement 12 mechanisch vorgespannt und somit in den anderen Zustand umgeschaltet ist. Die Aktorvorrichtung 22 ist in dieser Ausführungsform als "normales" Federelement 28 ausgebildet und weist zur Bildung der Verrastung 40 eine Hintergriffstruktur 42 auf, die einen Endbereich des Schaltelements 12 hintergreift.

Die Fig. 3C zeigt die aufgetrennte Verbindung 16 mit dem Schaltelement 12 und der Aktorvorrichtung 22 nach Umschalten in den auslösbaren Zustand, bei dem das Schaltelement 12 von der mittels des Auslöseelements 24 auslösbaren Aktorvorrichtung 22 verlagerbar ist (Fig. 3B), und nach dem anschließenden Auslösen durch das Auslöseelement 24. Das vorgespannte Federelement 28 der Aktorvorrichtung 22 zieht den einen Endbereich 36 vom Schmelzelement 26 weg, sodass die elektrisch leitende Verbindung 14 getrennt wird.

Die Figuren 4 bis 6 und 7 bis 9 zeigen die Überlastschutzvorrichtung 10 im Kontext einer Anordnung des auf einem Leiterbahnenträger (insbesondere Leiterplatte, Platine) 44 montierten elektrischen Bauelements 20. Das Bauelement 20 ist dabei als oberflächenmontierbares elektronisches Bauelement ausgebildet, das mit seinen Anschlüssen 18, 46 auf den Leiterbahnen 48 des Leiterbahnenträgers 44 mittels Wiederaufschmelz-Lötverfahren elektrisch kontaktiert ist.

Die Figuren 4 bis 6 zeigen eine Anordnung, bei der die Überlastschutzanordnung 10 die Anschlüsse 18, 46 mittels des als Kurzschlussbügel ausgebildeten Schaltelements 12 bei thermischer Überlast kurzschließt. Das elektrisch leitfähige Schaltelement 12 wird zu dem Bauelement 20 angeordnet. Das Schaltelement 12 wird auf dem Träger 44 befestigt. Zusammen mit einem auf dem Träger 44 befestigten und als Kurzschlussmetall ausgebildeten Stromführungselement 50 bildet ein Endbereich 36 des Schaltelements 12 einen elektrischen Schalter.

Dabei zeigt Fig. 4 die Überlastschutzanordnung 10 mit dem Schaltelement 12 und der Aktorvorrichtung 22 in einem inaktiven Zustand, bei dem das Schaltelement 12 von der Aktorvorrichtung 22 auch durch ein Auslösen mittels des Auslöseelements 24 nicht verlagerbar ist beziehungsweise verlagert wird, da die Aktorvorrichtung in diesem Zustand keine Kraft auf das Schaltelement 12 ausübt. Das Auslöseelement 24 ist auch hier als Schmelzelement 26 ausgebildet.

Die Fig. 5 zeigt die Überlastschutzanordnung 10 mit dem Schaltelement 12 und der Aktorvorrichtung 22 nach einem Umschalten in den auslösbaren Zustand, bei dem das Schaltelement 12 von der mittels des Auslöseelements 24 auslösbaren Aktorvorrichtung 22 verlagerbar ist. Mittels der manuell aufzubringenden Kraft wird die Aktorvorrichtung 22 gegenüber dem Schaltelement 12 so verbogen/verschwenkt, dass die Aktorvorrichtung 22 mittels einer Verrastung (nicht gezeigt) am Schaltelement 12 mechanisch vorgespannt und somit in den auslösbaren Zustand umgeschaltet ist. Die Aktorvorrichtung 22 ist in dieser Ausführungsform als Federelement 28 ausgebildet.

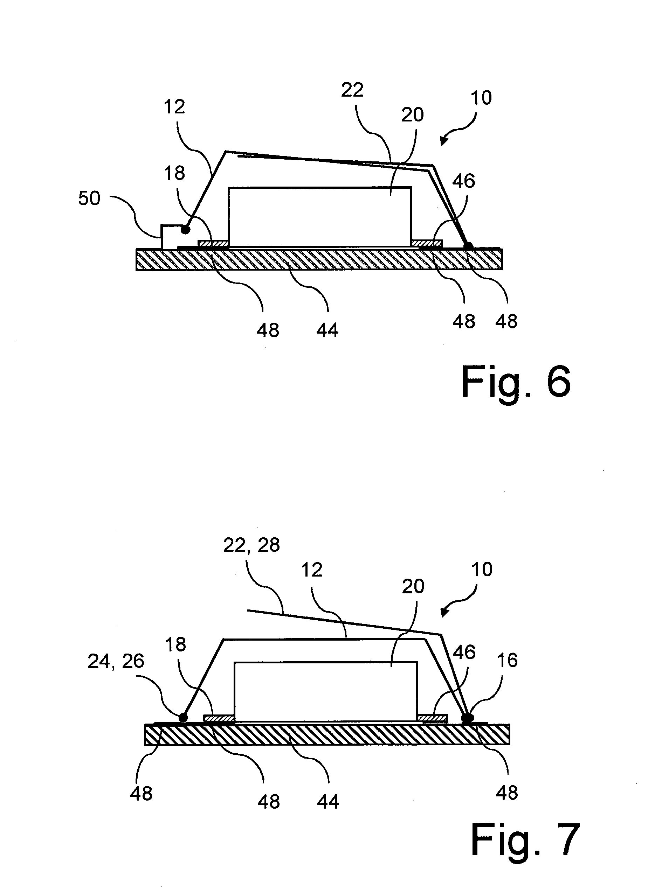

Die Fig. 6 zeigt das mittels des als Kurzschlussbügel ausgebildeten Schaltelements 12 kurzgeschlossene Bauelement 20 nach dem Auslösen durch das Auslöseelement 24. Das vorgespannte Federelement 28 der Aktorvorrichtung 22 zieht den einen Endbereich vom Schmelzelement 26 weg, sodass über das hakenförmig ausgebildete Stromführungselement 50 und entsprechende Leiterbahnen der Kurzschluss entsteht (nicht gezeigt).

Es ergeben sich folgende Vorteile: Im Montagezustand der Überlastschutzvorrichtung 10 ist diese kraftfrei. Die Montage auf dem Träger 44 kann durch einfache Bestückung, insbesondere mittels eines Bestückungsautomaten, erfolgen. Für den Lötprozess ist keine Fixierung und kein Niederhalten erforderlich. Im Anschluss an die Montage / den Lötprozess kann die Vorrichtung durch gegenseitige Verrastung (bzw. Durchbeulen) von Schaltelement 12 und Federelement 28 aktiviert werden.

Im Betriebszustand ist der von Federelement 28 und Kontaktierungsstelle mit Schmelzelement 26 auf dem Träger 44 gebildete Schalter geöffnet. Eine unzulässige Erwärmung des Bauelements 20 über die Aktivierungstemperatur hinaus führt zu einer Aktivierung der sich im auslösbaren Zustand befindlichen Vorrichtung 10. Beim Überschreiten der Aktivierungstemperatur (Lotschmelztemperatur) führt die Federspannung des Federelements 28 zum Schließen des so gebildeten Schalters und das Bauelement 20 ist damit in einen sicheren Zustand überführt.

Die Figuren 7 bis 9 zeigen eine Anordnung, bei der die Überlastschutzanordnung 10 die elektrisch leitende Verbindung 14 zwischen einem der Anschlüsse 18 und einem Stromführungselement 16 der Überlastschutzvorrichtung 10 bei thermischer Überlast auftrennt. Diese Anordnung entspricht im Wesentlichen der in den Figuren 3A bis 3C beschriebenen Anordnung.

Das elektrisch leitfähige Schaltelement 12 wird zu dem Bauelement 20 angeordnet. Das Schaltelement 12 wird auf dem Träger 44 befestigt. Zusammen mit einer Kontaktierungsstelle auf dem Träger 44 bildet ein Endbereich 36 des Schaltelements 12 einen elektrischen Schalter.

Die Fig. 7 zeigt die Überlastschutzanordnung 10 mit dem Schaltelement 12 und der Aktorvorrichtung 22 in einem inaktiven Zustand, bei dem das Schaltelement 12 von der Aktorvorrichtung 22 auch durch ein Auslösen mittels des Auslöseelements 24 nicht verlagerbar ist beziehungsweise verlagert wird, da die Aktorvorrichtung in diesem Zustand keine Kraft auf das Schaltelement 12 ausübt. Das Auslöseelement 24 ist auch hier als Schmelzelement 26 ausgebildet.

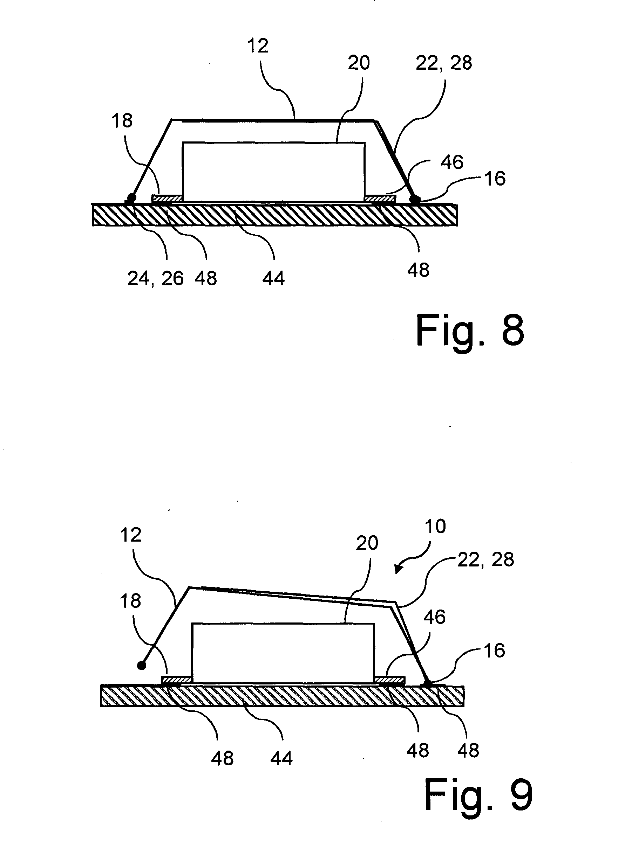

Die Fig. 8 zeigt die elektrisch leitende Verbindung 16 mit dem Schaltelement 12 und der Aktorvorrichtung 22 nach einem Umschalten in einen auslösbaren Zustand, bei dem das Schaltelement 12 von der mittels des Auslöseelements 24 auslösbaren Aktorvorrichtung 22 verlagerbar ist. Mittels manuell aufzubringender Kraft wird die Aktorvorrichtung 22 gegenüber dem Schaltelement 12 so verbogen, dass die Aktorvorrichtung 22 mittels einer Verrastung 40 am Schaltelement 12 mechanisch vorgespannt und somit in den anderen Zustand umgeschaltet ist. Die Aktorvorrichtung 22 weist zur Bildung der Verrastung 40 eine Hintergriffstruktur 42 auf, die einen Endbereich des Schaltelements 12 hintergreift (nicht gezeigt).

Die Fig. 9 zeigt die aufgetrennte Verbindung 16 mit dem Schaltelement 12 und der Aktorvorrichtung 22 nach einem Umschalten in den auslösbaren Zustand, bei dem das Schaltelement 12 von der mittels des Auslöseelements 24 auslösbaren Aktorvorrichtung 22 verlagerbar ist, und einem anschließenden Auslösen durch das Auslöseelement 24. Das vorgespannte Federelement 28 der Aktorvorrichtung 22 zieht den einen Endbereich vom Schmelzelement 26 weg, sodass die elektrisch leitende Verbindung 14 getrennt wird.

Es ergeben sich folgende Vorteile: Im Montagezustand der Überlastschutzvorrichtung 10 ist diese kraftfrei. Die Montage auf dem Träger 44 kann durch einfache Bestückung, insbesondere mittels eines Bestückungsautomaten, erfolgen. Für den Lötprozess ist keine Fixierung und kein Niederhalten erforderlich. Im Anschluss an die Montage / den Lötprozess kann die Vorrichtung durch gegenseitige Verrastung (bzw. Durchbeulen) von Schaltelement 12 und Federelement 28 aktiviert werden.

Im Betriebszustand ist der von Federelement 28 und Kontaktierungsstelle mit Schmelzelement 26 auf dem Träger 44 gebildete Schalter geschlossen. Eine unzulässige Erwärmung des Bauelements 20 über die Aktivierungstemperatur führt zu einer Aktivierung der sich im auslösbaren Zustand befindlichen Vorrichtung 10. Beim Überschreiten der Aktivierungstemperatur (Lotschmelztemperatur) führt die Federspannung des Federelements 28 zum Öffnen des so gebildeten Schalters und das Bauelement 20 ist damit in einen sicheren Zustand überführt.

### Bezugszeichenliste

- Überlastschutzvorrichtung: 10
- Schaltelement: 12
- leitende Verbindung: 14
- Stromführungselement: 16
- Anschluss: 18
- Bauelement: 20
- Aktorvorrichtung: 22
- Auslöseelement: 24
- Schmelzelement: 26
- Federelement: 28
- streifenförmiger Bereich: 30
- streifenförmiger Bereich: 32
- streifenförmiger Bereich: 34
- Endbereich: 36
- Endbereich: 38
- Verrastung: 40
- Hintergriffstruktur: 42
- Leiterbahnenträger: 44
- Anschluss: 46
- Leiterbahn: 48
- Stromführungselement: 50
- Pfeil: F

## Patentansprüche

1. Thermische Überlastschutzvorrichtung (10) zum Schutz eines elektrischen Bauelements (20), insbesondere elektronischen Bauelements, die ein Schaltelement (12) zum Kurzschließen von Anschlüssen (18, 46) des Bauelements (20) oder zum Auftrennen einer elektrisch leitenden Verbindung (14) zwischen mindestens einem der Anschlüsse (18) und einem Stromführungselement (16) der Überlastschutzvorrichtung (10), eine Aktorvorrichtung (22) zum Verlagern des Schaltelements (12) in eine entsprechende Kurzschlussposition oder Trennposition und ein die Aktorvorrichtung (22) thermosensitiv auslösendes Auslöseelement (24) aufweist, wobei die Aktorvorrichtung (22) zu ihrer Aktivierung von einem inaktiven Zustand, bei dem das Schaltelement (12) von der Aktorvorrichtung (22) auch durch Auslösen mittels Auslöseelement (24) nicht verlagerbar ist, in einen auslösbaren Zustand umschaltbar ist, bei dem das Schaltelement (12) von der Aktorvorrichtung (22) verlagerbar ist, **dadurch gekennzeichnet, dass** die Aktorvorrichtung (22) im umgeschalteten Zustand eine mittels einer Verrastung (40) am Schaltelement (12) mechanisch vorgespannte Aktorvorrichtung (22) ist.

2. Überlastschutzvorrichtung nach Anspruch 1, wobei das Auslöseelement (24) als ein durch Schmelzen auslösendes Schmelzelement (26) ausgebildet ist.

3. Überlastschutzvorrichtung nach Anspruch 1 oder 2, wobei die Aktorvorrichtung (22) eine durch manuelle Veränderung der äußeren Form der Aktorvorrichtung (22) oder der Anordnung der Aktorvorrichtung (22) relativ zum Schaltelement (12) umschaltbare Aktorvorrichtung (22) ist.

4. Überlastschutzvorrichtung nach einem der vorhergehenden Ansprüche, wobei die Aktorvorrichtung (22) mindestens ein Federelement (28) aufweist, insbesondere ein Federelement (28) ist.

5. Überlastschutzvorrichtung nach Anspruch 4, wobei das Federelement (28) eine Schnappscheibe ist.

6. Überlastschutzvorrichtung nach einem der vorhergehenden Ansprüche, wobei die Aktorvorrichtung (22) ein intumeszentes Material und/oder ein Formgedächtnismaterial und/oder ein seine Form chemisch veränderndes Material als aktives Material aufweist.

7. Überlastschutzvorrichtung nach einem der vorhergehenden Ansprüche, wobei das Schaltelement (12) und die Aktorvorrichtung (22) einstückig ausgebildet sind oder zumindest ein einstückig ausgebildetes gemeinsames Teil aufweisen.

8. Überlastschutzvorrichtung nach einem der vorhergehenden Ansprüche, wobei das Bauelement (20) ein von der Überlastschutzvorrichtung (10), insbesondere von dem Schaltelement (12), separierbares Bauelement (20) ist.

9. Anordnung mit einem Leiterbahnenträger (44), mindestens einem darauf angeordneten Bauelement (20) und mindestens einer Überlastschutzvorrichtung (10) nach einem der Ansprüche 1 bis 8.

10. Anordnung nach Anspruch 9, wobei sich das Schaltelement (12) und/oder die Aktorvorrichtung (22) der Überlastschutzvorrichtung (10) über das Auslöseelement (24) am Bauelement (20) oder einer mit einem Anschluss (18, 46) des Bauelements (20) unmittelbar verbundenen Leiterbahn (48) des Leiterbahnenträgers (44) abstützen.

11. Anordnung nach Anspruch 9 oder 10, wobei sich das Schaltelement (12) und/oder die Aktorvorrichtung (22) der Überlastschutzvorrichtung (10) unmittelbar an mindestens einer einen der Anschlüsse (18, 46) kontaktierenden Leiterbahnen (48) abstützen.

## Claims

1. A thermal overload protection device (10) for protecting an electrical component (20), in particular an electronics component, said thermal overload protection device having a switching element (12) for short-circuiting connection points (18, 46) of the component (20) or for disconnecting an electrically conductive connection (14) between at least one of the connection points (18) and a current-conveying element (16) of the overload protection device (10), an actuator device (22) for moving the switching element (12) into an appropriate short-circuiting position or disconnection position, and a tripping element (24) which trips the actuator device (22) on a thermally sensitive basis, wherein the actuator device (22) can be switched over for activation from an inactive state, in which the switching element (12) cannot be moved by the actuator device (22), not even as a result of tripping by means of the tripping element (24), into a trippable state, in which the switching element (12) can be moved by the actuator device (22), **characterised in that** the actuator device (22) in the switched-over state is an actuator device (22) mechanically biased by means of a latch (40) at the switching element (12).

2. The overload protection device according to Claim 1, wherein the tripping element (24) is formed as a fusible element (26) tripped by melting.

3. The overload protection device according to Claim 1 or 2, wherein the actuator device (22) is an actuator device (22) that can be switched over by manually changing the outer shape of the actuator device (22) or the arrangement of the actuator device (22) relative to the switching element (12).

4. The overload protection device according to one of the preceding claims, wherein the actuator device (22) has at least one spring element (28), and in particular is a spring element (28).

5. The overload protection device according to claim 4, wherein the spring element (28) is a snap dome.

6. The overload protection device according to one of the preceding claims, wherein the actuator device (22) has an intumescent material and/or a shape-memory material and/or a material of chemically changing form as active material.

7. The overload protection device according to one of the preceding claims, wherein the switching element (12) and the actuator device (22) are formed in one piece or comprise at least one common part formed in one piece.

8. The overload protection device according to one of the preceding claims, wherein the component (20) is a component (20) that can be separated from the overload protection device (10), in particular by the switching element (12).

9. An arrangement comprising a conducting track support (44), at least one component (20) arranged thereon and at least one overload protection device 910) according to one of Claims 1 to 8.

10. The arrangement according to Claim 9, wherein the switching element (12) and/or the actuator device (22) of the overload protection device (10) is/are supported on the component (20) via the tripping element (24) or via a conducting track (48) of the conducting track support (44) connected directly to a connection point (18, 46) of the component (20).

11. The arrangement according to Claim 9 or 10, wherein the switching element (12) and/or the actuator device (22) of the overload protection device (10) is/are supported directly on at least one conducting track (48) contacting one of the connection points (18, 46).

## Revendications

1. Dispositif thermique de protection contre les surcharges (10) pour la protection d'un élément de construction électrique (20), en particulier d'un élément de construction électronique, comportant un élément de commutation (12) destiné à court-circuiter des connexions (18, 46) de l'élément de construction (20) ou à couper une liaison électriquement conductrice (14) entre au moins l'une des connexions (18) et un élément d'alimentation en courant (16) du dispositif de protection contre les surcharges (10), un dispositif d'actionnement (22) destiné à déplacer l'élément de commutation (12) vers une position de court-circuit ou une position de coupure correspondante, ainsi qu'un élément déclencheur (24) destiné à déclencher le dispositif d'actionnement (22) de façon thermosensible, dans lequel, pour être activé, le dispositif d'actionnement (22) peut être commuté d'un état inactif, dans lequel l'élément de commutation (12) ne peut pas être déplacé par le dispositif d'actionnement (22), même pas par déclenchement au moyen de l'élément déclencheur (24), vers un état déclenchable, dans lequel l'élément de commutation (12) peut être déplacé par le dispositif d'actionnement (22), **caractérisé en ce que** dans l'état commuté, le dispositif d'actionnement (22) est un dispositif d'actionnement (22) précontraint mécaniquement au moyen d'un crantage (40) sur l'élément de commutation (12).

2. Dispositif de protection contre les surcharges selon la revendication 1, dans lequel l'élément déclencheur (24) est conçu comme un élément fusible (26) pour un déclenchement par fusion.

3. Dispositif de protection contre les surcharges selon la revendication 1 ou 2, dans lequel le dispositif d'actionnement (22) est un dispositif d'actionnement (22) commutable par une modification manuelle de la forme extérieure du dispositif d'actionnement (22) ou de l'agencement du dispositif d'actionnement (22) par rapport à l'élément de commutation (12).

4. Dispositif de protection contre les surcharges selon l'une des revendications précédentes, dans lequel le dispositif d'actionnement (22) comporte un élément de ressort (28), est en particulier un élément de ressort (28).

5. Dispositif de protection contre les surcharges selon la revendication 4, dans lequel l'élément de ressort (28) est un disque à déclic.

6. Dispositif de protection contre les surcharges selon l'une des revendications précédentes, dans lequel le dispositif d'actionnement (22) comporte un matériau intumescent et/ou un matériau à mémoire de forme et/ou un matériau de forme chimiquement modifiable, en tant que matériau actif.

7. Dispositif de protection contre les surcharges selon l'une des revendications précédentes, dans lequel l'élément de commutation (12) et le dispositif d'actionnement (22) sont conçus d'un seul tenant ou comportent au moins une partie commune conçue d'un seul tenant.

8. Dispositif de protection contre les surcharges selon l'une des revendications précédentes, dans lequel l'élément de construction (20) est un élément de construction (20) apte à être séparé du dispositif de protection contre les surcharges (10), en particulier de l'élément de commutation (12).

9. Agencement avec un support de pistes conductrices (44), au moins un élément de construction (20) agencé sur celui-ci et au moins un dispositif de protection contre les surcharges (10) selon l'une des revendications 1 à 8.

10. Agencement selon la revendication 9, dans lequel l'élément de commutation (12) et/ou le dispositif d'actionnement (22) du dispositif de protection contre les surcharges (10) s'appuient sur l'élément de construction (20) par le biais de l'élément déclencheur (24) ou d'une piste conductrice (48) du support de pistes conductrices (44) reliée directement à une connexion (18, 46) de l'élément de construction (20).

11. Agencement selon la revendication 9 ou 10, dans lequel l'élément de commutation (12) et/ou le dispositif d'actionnement (22) du dispositif de protection contre les surcharges (10) s'appuient directement sur au moins une piste conductrice (48) en contact avec l'une des connexions (18, 46).
